# EUROPEAN PATENT SPECIFICATION

(11) **EP 0 476 837 B1**
(45) Date of publication and mention of the grant of the patent: **22.05.1996**
(21) Application number: 91307617.0
(22) Date of filing: 19.08.1991
(51) Int. Cl.: G03F 9/00, G03B 27/53

(54) **An automatic optical exposing apparatus**
Automatisches optisches Belichtungsgerät
Appareil d'exposition optique automatique

(30) Priority: 27.08.1990 JP 224659/90
(43) Date of publication of application: 25.03.1992
(73) Proprietor: ORC MANUFACTURING CO., LTD., Chofu-shi, Tokyo (JP)
(72) Inventor: Yazaki, Yoshio, Chofu-shi, Tokyo (JP)
(74) Representative: Hillier, Peter

(56) References cited:
- US-A- 4 996 763

## Description

The present invention relates generally to an automatic optical exposing apparatus. More particularly, the present invention relates to an automatic optical exposing apparatus which assures that positional alignment of a work such as a printed circuit board or the like with a mask film is automatically executed in other region rather than an optical exposing stage, and moreover, the work is displaced at a high operational efficiency.

An automatic optical exposing apparatus including an automatic positional aligning unit having steps of image recognizing and recognized image processing employed therefor was invented by a common inventor to the present invention and a patent application of the prior invention was already filed with the Patent Office in Japan by him under Japanese Laid-Open Patent NO. 302259/1989. According to the prior invention, automatic positional alignment of a work with a mask film is previously conducted in other location rather than an optical exposing chamber. Thereafter, the work is introduced into the optical exposing chamber.

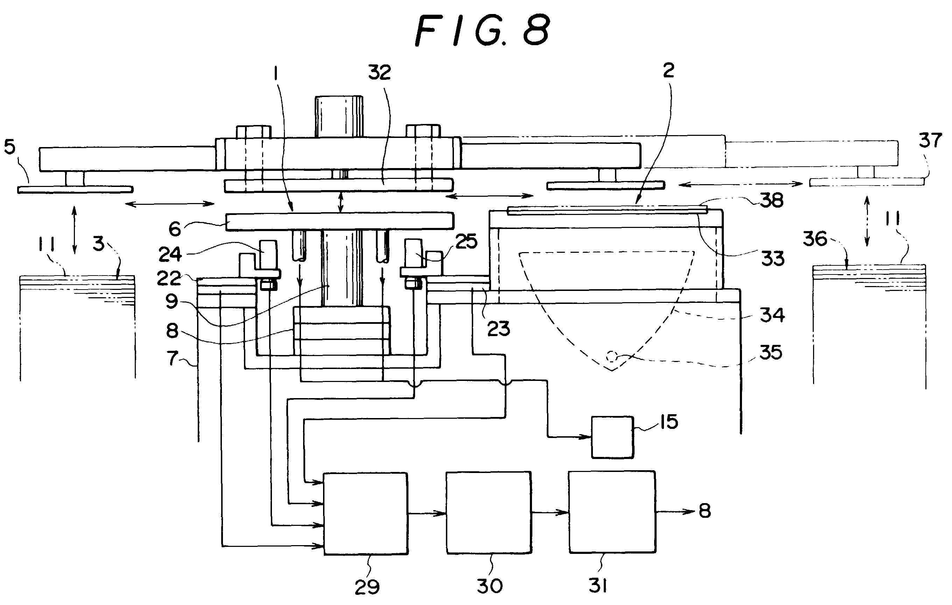

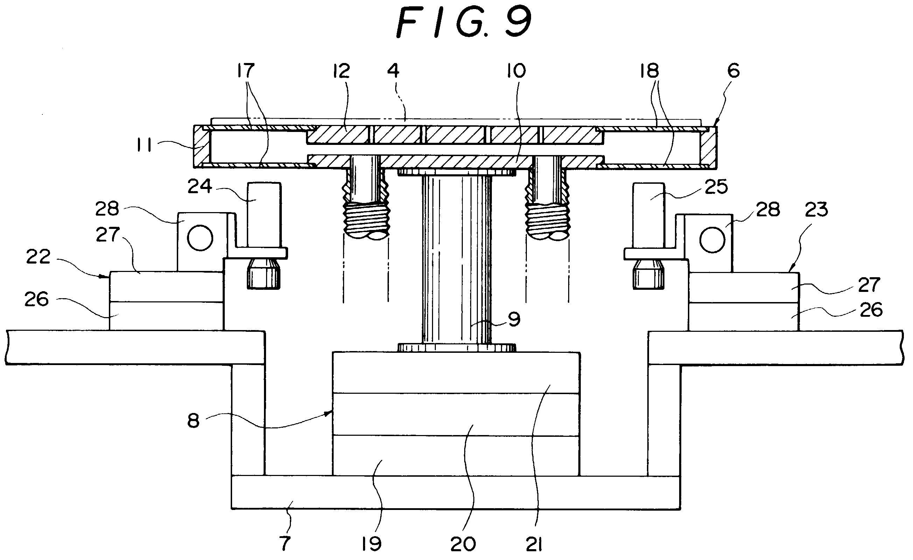

To facilitate understanding of the present invention, the conventional automatic optical exposing apparatus will be described below with reference to Fig. 8 and Fig. 9.

Fig. 8 is an illustrative view which schematically illustrates shows a fundamental structure of the conventional automatic optical exposing apparatus, and Fig. 9 is an illustrative view which schematically shows arrangement of essential components constituting an automatic positional aligning unit in the conventional automatic optical exposing apparatus. In Fig. 8 and Fig. 9, reference numeral 1 designates an automatic aligning unit adapted to serve as a position aligning stage, reference numeral 2 designates an optical exposing stage, reference numeral 3 designates a work infeed stocker adapted to serve as a work infeed stage, and reference numeral 36 designates a work outfeed stocker adapted to serve as a work outfeed stage. In addition, reference numeral 5 designates a work infeed handler for conveying a work 11 from the work infeed stocker 3 to an alignment table 6, and reference numeral 32 designates a traverser. The traverser 32 serves to convey onto a mask film 38 immovably held on the surface of a printing frame glass plate 33 the work 11 which has completed a position aligning operation on the alignment table 6 based on data on the position of the mask film 38 previously memorized in the memory of a comparing/determining unit 30. Additionally, reference numeral 37 designates a work outfeed stocker for downwardly displacing each work 11 to the work outfeed stocker 36 after completion of a printing operation at the optical exposing stage 2. As is best seen in Fig. 8, the work infeed handler 5, the traverser 32 and the work outfeed handler 37 are successively operatively connected to each other. Further, reference numeral 15 designates a vacuum pump for evacuating the alignment table 6 in the automatic aligning unit 1.

A number of unexposed works 11 are stored in the work infeed stocker 3 in a laminated state. In operation, the work infeed handler 5 successively picks up each works 11 from the uppermost end of the laminates structure of the works 11 by an attractive force of the work infeed handler 5 and then conveys the sucked-up work 11 to the alignment table 6. It should be noted that a method of storing the works 11 in the work infeed stocker 3 is not practiced in such a manner that the works 11 are located in correct alignment with the center position of the work infeed stocker 3.

Next, description will be made below with respect to a method of correctly positioning each work 11 in the automatic aligning unit 1.

Prior to description of the foregoing positioning method, the structure of the automatic aligning unit 1 will be described below. As shown in Fig. 9, the alignment table 6 is mounted on a base 7 via a motor driving mechanism 8 and a support rod 9. In Fig. 9, reference numeral 19 designates a X-coordinate driving mechanism for the support rod 9, reference numeral 20 designates a Y-coordinate driving mechanism for the same, and reference numeral 21 designates a rotationally driving mechanism for rotating the support shaft 9 by an angle of THETA. Transparent windows 17 and 18 each having a considerably wide area are formed on a lower plate 10 and an upper plate 11 each constituting the alignment table 6. In addition, the automatic aligning unit 1 is provided with camera position adjusting mechanisms 22 and 23, and each of the camera position adjusting mechanisms 22 and 23 includes a X-coordinate driving mechanism 26 for displacing each camera in the X-coordinate direction and a Y-coordinate driving mechanism 27 for displacing it in the Y-coordinate direction and a driving mechanism 28 for displacing it in the direction of a height, i.e., in the Z-coordinate direction.

To preparatively locate the work 11 in alignment with the mask film 38, the mask film 38 is first placed on the alignment table 6.

Subsequently, to photograph two or more alignment marks on the mask film 38, each camera is dislocated by acutating the camera position adjusting mechanisms 22 and 23 so that the alignment marks are optically detected by the cameras 24 and 25.

As shown in Fig. 8, an alignment mark position detecting unit 29 is constructed such that signals each representing the position of an image receiving region of each camera, signals representing the dislocated positions of the cameras 24 and 25 and signals each representing the position of each alignment mark are inputted into the alignment mark detecting unit 29 so as to detect the positions of the respective alignment marks, and the present position of the work 11 is then determined based on the detected positions of the respective alignment marks. Signals outputted from the alignment mark position detecting unit 29 to represent the detected positions of the respective alignment marks are inputted into the comparing/determining unit 30 so that the detected positions of the respective alignment marks are memorized in the comparing/determining unit 30. After the positions of the respective alignment marks are detected, the mask film 38 is conveyed onto the printing frame glass plate 33 of the optical exposing stage 2 and it is then immovably held on the printing frame glass plate 33 using a tape or the like. At this time, the positions of the respective alignment marks on the mask film 38 immovably held on the printing frame glass plate 33 correctly coincide with the positions of the respective alignment marks on the mask film 38 which have been measured on the alignment table 6.

Next, the work infeed handler 5 picks up another work 11 in the work infeed stocker 3 by the attractive force of the work infeed handler 5 so as to place the work 11 on the alignment table 6. While the work 11 is placed on the alignment table 6, the alignment table 11 is evacuated by the vacuum pump 15, whereby the work 11 is firmly held on the alignment table 6. The positions of the alignment marks on the work 11 are detected by the alignment mark position detecting unit 29 with the aid of the cameras 24 and 25. In response to signals representing the detected positions of the alignment marks on the work 11, the comparing/determining unit 30 determines whether or not data derived from the foregoing signals coincide with the data on the positions of the respective alignment marks memorized in the comparing/ determining unit 30, and the motor driving mechanism 8 is controllably driven with the aid of a driving/controlling unit 31 until the both data coincide with each other. Thus, the alignment table 6 is displaced in the X-coordinate direction, in the Y-coordinate direction and in the leftward/rightward direction of rotation by a certain quantity so as to correctly determine the positions of the respective alignment marks on the work 11. On completion of the position determining operation, the alignment marks on the work 11 on the alignment table 6 coincide with the alignment marks on the mask film 38 immovably held on the printing frame glass plate 33. Subsequently, the traverser 32 conveys the work 11 on the alignment table 6 to the optical exposing stage 2 so that the work 11 is placed on the mask film 38 immovably held on the printing frame glass plate 33.

With the position determining method as mentioned above, three conveying means, i.e., the work infeed handler 5 for conveying each work 11 from the work infeed stage to the position aligning stage, the traverser 32 for conveying the work 11 from the position aligning stage to the optical exposing stage after the alignment marks on the work 11 are aligned with the alignment marks on the mask film 38 and the work outfeed handler 37 for conveying the work 11 from the optical exposing stage to the work outfeed stage are driven by a single driving power supply source at a high operational efficiency. However, since the conventional automatic optical exposing apparatus 1 does not have any particular function of locating the work in alignment with the center of the work infeed stage, there arise problems that a time required for correctly aligning the position of each work with the position of the mask film on the alignment table 6 fluctuates from work to work, and moreover, a series of the aforementioned processing cannot be executed on the real time basis.

In addition, the work infeed handler, the traverser and the work outfeed handler are constructed as means for holding each work by using a rubber pad having a number of evacuation holes formed thereon, respectively. With this construction, since the rubber pads used for the traverser and the work outfeed handler are repeatedly exposed to bright light at the optical exposing stage, there arise another problems that there is a need of frequently replacing the rubber pads with new ones due to a degraded property of light resistance, an evacuation time is elongated due to leakage of air through the evacuation holes on each rubber pad because dimensions of each work are not always kept constant, and moreover, the work is undesirably dislocated from a predetermined position during an evacuating operation.

The present invention has been made in consideration of the aforementioned problems.

An object of the present invention is to provide an automatic optical exposing apparatus having an excellent property of resistance against exposing light irradiated at an optical exposing stage and a small requirement of replacement of rubber pads with new ones.

Another object of the present invention is to provide an automatic optical exposing apparatus including work holding means without an occurrence of dislocation of each work.

Another object of the present invention is to provide an automatic optical exposing apparatus which assures that automatic alignment of a work with a mask film can be executed at another stage different from an optical exposing stage.

Yet another object of the present invention is to provide an automatic optical exposing apparatus which assures that automatic alignment of a work with a mask film can be achieved within a short period of time.

According to the present invention, there is provided an automatic optical exposing apparatus provided with a work infeed stage, a position aligning stage to receive an unexposed work being conveyed from the work infeed stage through a traverser to place said work on an alignment table in the position aligning stage, the alignment table being automatically moved to adjust to place said work to a predetermined exposing position when said work is conveyed to a next exposing stage, the exposing stage serving to expose said unexposed work which is conveyed from the position aligning stage through the traverser by closely attaching said work to a mask film fixed on a lower printing frame in the exposing stage, and an outfeed stage to feed out said exposed work conveyed from the exposing stage through the traverser, characterized in that said work infeed stage is provided with a device to automatically place the central position of said unexposed work at a predetermined position in said infeed stage, by a conveying system including three sets of work holding mechanism and reciprocating between the two adjacent stages among said infeed stage, position aligning stage, exposing stage and outfeeding stage, and in that said work holding mechanism of the conveying system reciprocating between said position aligning stage and said exposing stage is formed as a reduced pressure housing provided with a plurality of air suction slits or holes and functions as an upper printing frame.

In an embodiment of the present invention, the work infeed stage for receiving and conveying the work includes a plurality of rollers for allowing the work infeed stage having the work mounted thereon to be conveyed to a predetermined position where conveyance of the work infeed stage is stopped, a plurality of locator pins rotatably disposed on mounting bases at the opposite ends of each of locators arranged in four directions composed of forward and rearward directions and leftward and rightward directions relative to the rollers, springs disposed sideward of the rollers such that a resilient squeezing force of each of the springs can be varied as desired, and controlling means for controlling the speed of a driving motor for two endless timing belts operable not only in the a X-coordinate direction and but also in the Y-coordinate direction operatively connected to the mounting bases wherein the speed of the driving motor is controlled corresponding to a thickness of the work.

With the automatic optical exposing apparatus of the present invention constructed in the above-described manner, since a work is introduced into an optical exposing chamber after each work is previously automatically aligned with the mask film in other location rather than the optical exposing chamber, the present invention has provided an automatic aligning system preferably employable for mass production. In addition, since three work holding mechanisms reciprocably displaceable within the operative range defined by a work infeed stage, a position aligning stage, an optical exposing stage and a work outfeed stage are conveyed by a single driving system, the result is that the automatic optical exposing apparatus is simple in structure and operation of the automatic optical exposing apparatus can be simplified. Additionally, since a vacuum chamber of the evacuating unit can be divided into two zones or four or more zones, each work can easily be held without any particular measure for preventing air leakage no matter how many kinds of works are to be subjected to optical exposing. Further, since the work outfeed stage is constructed such that a reduced pressure housing is divided into two sections with respect to a single mask film, the work can easily be peeled from the mask film. Moreover, since a prealignment stage is employed for the work infeed stage so that a work to be conveyed to an automatic aligning unit is properly located, a position aligning operation can be performed for the work at the alignment table within a short period of time.

Other objects, features and advantages of the present invention will become apparent from reading of the following description which has been made in conjunction with the accompanying drawings.

The present invention is illustrated in the following drawings.

Fig. 1 is a partially exploded of work conveying means constituting an automatic optical exposing apparatus in accordance with an embodiment of the present invention.

Fig. 2 is a partially exploded front view of the work conveying means shown in Fig. 1.

Fig. 3 is a perspective view which schematically illustrates arrangement of a work infeed handler, a traverser and a work outfeed handler each constituting the automatic optical exposing apparatus.

Fig. 4 is a perspective view which illustrates the structure of a prealignment stage serving as a work infeed stage.

Fig. 5 is a plan view of the prealignment stage shown in Fig. 4.

Fig. 6 is a sectional view which schematically illustrates arrangement of a locator and locator pins.

Fig. 7 is a fragmentary plan view of the locator and the locator pins shown in Fig. 6.

Fig. 8 is an illustrative view which schematically shows the structure of a conventional automatic optical exposing apparatus.

Fig. 9 is a partially exploded front view of an automatic aligning unit constituting the conventional automatic optical exposing apparatus shown in Fig. 8, particularly illustrating essential components for the automatic aligning unit.

Now, the present invention will be described in detail hereinafter with reference to the accompanying drawings which illustrates a preferred embodiment of the present invention.

An automatic optical exposing apparatus in accordance with the embodiment of the present invention includes an automatic aligning unit for locating a work in alignment with a mask film and an optical exposing stage for printing an image of the mask film onto the work, and the automatic aligning unit and the optical exposing stage are same in structure to those in the conventional automatic optical exposing apparatus which has been described above with reference to Fig. 8 and Fig. 9. However, it should be noted that a mechanism for successively operatively connecting a work infeed stage, a position aligning stage, an optical exposing stage and a work outfeed state to each other via work conveying means for the purpose of conveyance, a driving mechanism for driving the conveying means and a structure of the work introduction are not disclosed in conjunction with the conventional automatic optical exposing apparatus.

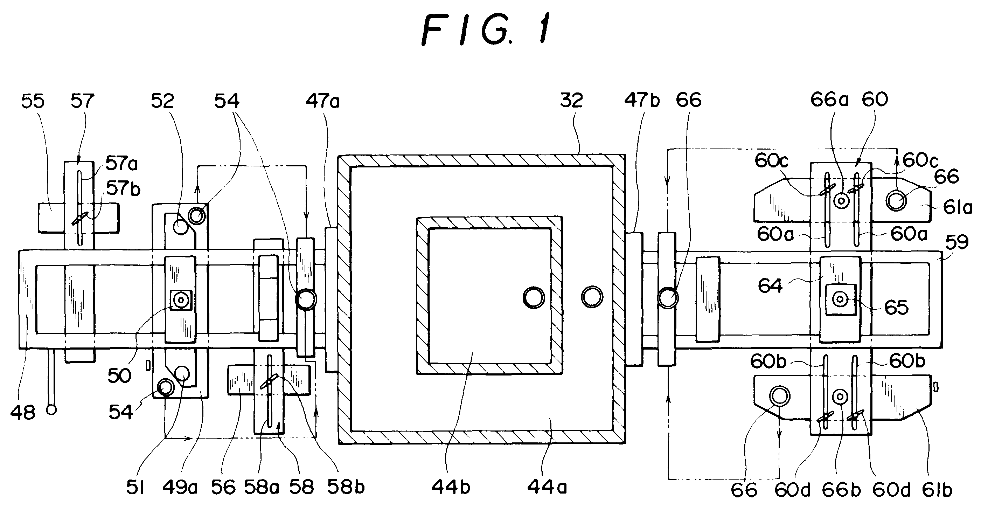

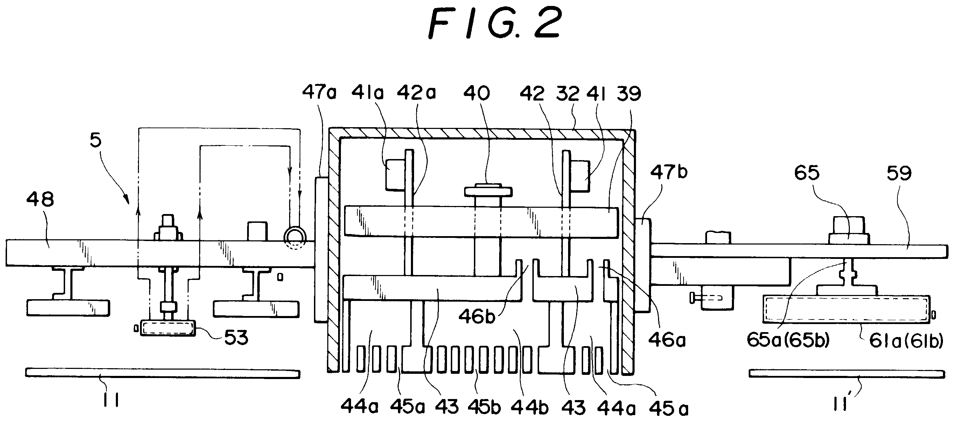

Fig. 1 is a partially exploded plan view which schematically illustrates a structure of the work conveying means and Fig. 2 is a front view of the work conveying means shown in Fig. 1. Next, a structure of the work conveying means constituting the automatic optical exposing apparatus in accordance with the embodiment of the present invention will be described below. It should be added that same components to those for the conventional automatic optical exposing apparatus are designated by same reference numerals.

In Fig. 1 and Fig. 2, reference numeral 32 designates a box-shaped traverser which serves also as an upper frame employable for a printing operation. A suspension type mounting plate 39 is fixedly secured to the traverser 32 via suitable means (not shown). A screw member 40 is attached to the mounting plate 39 using screws (not shown), and vertically displaceable rod members 42 and 42a operatively connected to pistons of cylinders 41 and 41a are inserted through the mounting plate 39 to be fixed to a ceiling plate 43 for a reduced pressure chamber. As the cylinders 41 and 41a are actuated, the ceiling plate 43 is displaced in the upward/ downward direction so that an available volume of the reduced pressure chamber can be varied as desired.

The reduced pressure chamber is divided into an outer reduced pressure chamber 44a and an inner reduced pressure chamber 44b, and a number of sucking holes 45a and 45b are formed on the bottom surfaces of the both reduced pressure chambers 44a and 44b. In addition, evacuation ports 46a and 46b communicated with a vacuum vessel (not shown) via stops valves (not shown) are formed on the upper walls of the reduced pressure chambers 44a and 44b. With such construction, a work (not shown) is removably secured to the traverser 32 under the effect of a reduced pressure induced by evacuation of the both reduced pressure chambers 44a and 44b through the sucking ports 45a and 45b and the evacuation ports 46a and 46b.

In Fig. 1 and Fig. 2, reference numeral 47a designates a traverser mounting plate. A handler supporting member 48 having an U-shaped cross-sectional contour is connected to the traverser mounting plate 47a. In addition, a supporting plate 49a is firmly placed on the handler supporting member 48 while extending in the transverse direction, and a cylinder 50 is operatively connected to the supporting plate 49a so that a reduced pressure chamber 53 can be displaced in the upward/downward direction relative to the handler supporting member 48 with the aid of auxiliary cylinder bars 51 and 52 which are inserted through the supporting plate 49a. The reduced pressure chamber 53 is communicated with the vacuum vessel (not shown) via a duct cord 54 extending through the supporting plate 49a and a regulating valve (not shown) so that each work 11 is removably attached to the reduced pressure chamber under the effect of a reduced pressure induced by evacuation of the reduced pressure chamber 53 through the duct cord 54.

In Fig. 2, reference numerals 55 and 56 designate illuminating instruments, respectively. Illuminating instrument supporting plates 57 and 58 are firmly secured to the handler supporting member 48 while extending in the transverse direction so that the illuminating instruments 55 and 56 can slidably be displaced on the horizontal plane of the supporting plates 57 and 58 in the transverse direction with the aid of guide grooves 57a and 58a and butterfly nuts and bolts 57b and 58b.

In addition, in Fig. 1 and Fig. 2, reference numeral 47b designates a traverser mounting plate. A handler supporting member 59 having an U-shaped cross-sectional contour is connected to the traverser mounting plate 47b. A supporting plate 60 is arranged while extending in the transverse direction relative to the handler supporting member 59 so that an opposing pair of reduced pressure sucking boxes 61a and 61b are displaceably secured to the supporting plate 60 at the opposite ends of the same. Thus, an opposing pair of reduced pressure sucking boxes 61a and 61b are supported by the supporting plate 60 such that their positions can be varied on the horizontal plane of the supporting plate 60 in the transverse direction with the aid of guide slits 60a and 60b formed on the supporting plate 60 and butterfly bolts 60c and 60d slidably received in the guide slits 60a and 60b. A cylinder 65 is operatively connected to the supporting plate 64 so that the reduced pressure boxes 61a and 61b can be displaced in the upward/downward direction relative to the handler supporting member 59 with the aid of auxiliary bars 66a and 66b inserted through the supporting plate 60. In Fig. 1, reference numeral 66 designates a duct code.

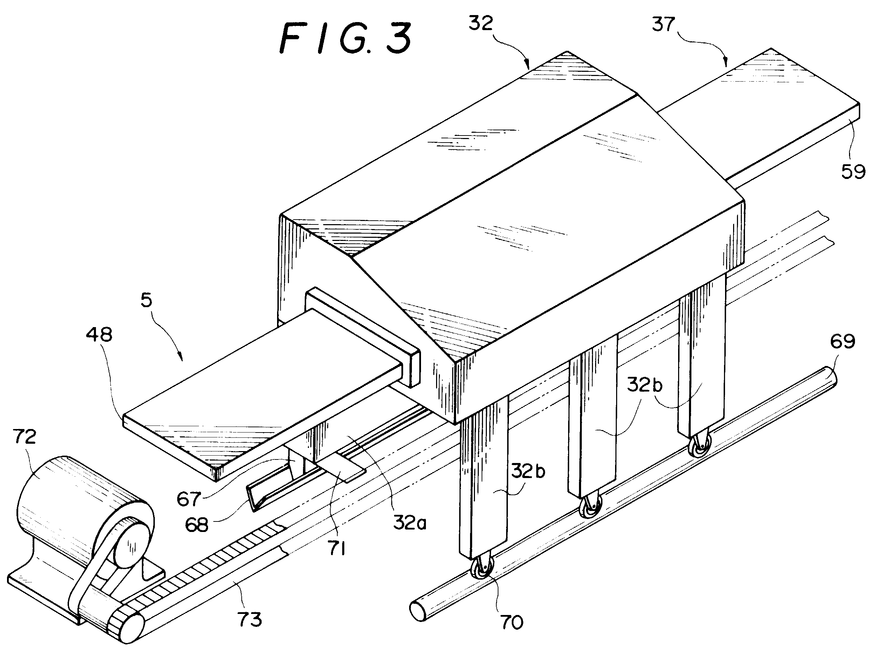

Fig. 3 is a perspective view which schematically illustrates the fundamental structure of a work infeed handler, a traverser and a work outfeed handler. In detail, Fig. 3 illustrates that the handler supporting member 48 of the work infeed handler 5 and the handler supporting member 59 of a work outfeed handler 37 are integrated with the traverser 32.

As shown in Fig. 1 and Fig. 2, the traverser 32 is constructed in the box-shaped configuration of which bottom surface is opened to the outside to serve as an upper frame of a printing frame for performing a printing operation at the printing stage. Referring to Fig. 3, the fore and rear surface sides of the traverser 32 is displaceably supported by a plurality of fore column-shaped members 32b and a rear plate-shaped member 32a. The lower end of the rear plate-shaped member 32a is tapered to form a V-shaped projection 67 which in turn is engaged with a V groove-shaped rail 68. On the other hand, a wheel 70 is rotatably mounted on the lower end of each of the fore column-shaped members 32b. In addition, the rear plate-shaped member 32a of the traverser 32 is fastened via a joint portion 71 to an endless timing belt 73 adapted to be recirculatively driven by a pulse motor 72.

As is apparent from the above description, since the traverser 32, the work infeed handler 5 and the work outfeed handler 37 are constructed in an integral structure, when a pulse signal is inputted into the pulse motor 72, the pulse motor 72 is driven so as to allow the work infeed handler 5 to convey a new work to the position aligning stage. Subsequently, the traverser 32 conveys the work of which position has been correctly aligned, from the position aligning stage to the printing stage. On completion of a printing operation, the work outfeed handler 37 conveys the work to a work outfeed stocker.

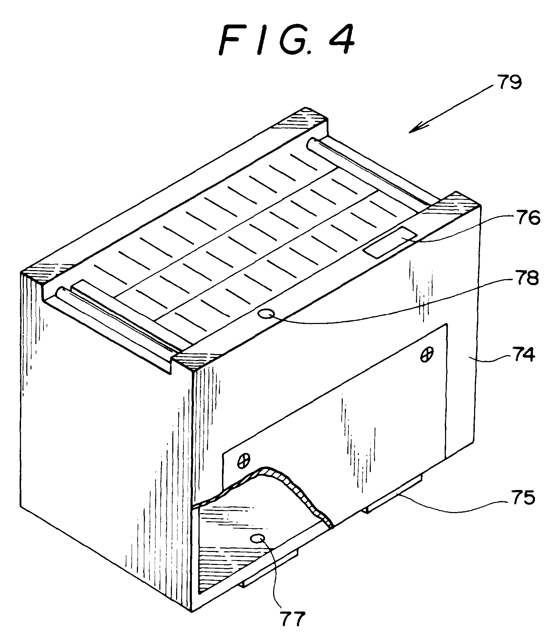

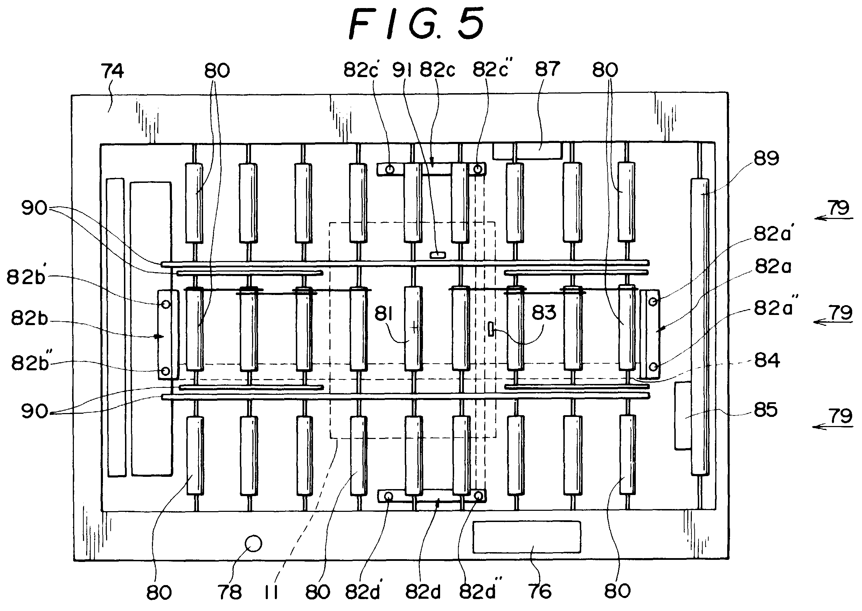

Next, a work infeed stage constituting the automatic optical exposing apparatus in accordance with the embodiment of the present invention will be described below with reference to Fig. 4, Fig. 5 and Fig. 6. Fig. 4 is a perspective view of the work infeed stage which serves as a prealignment stage to receive and convey a work, and Fig. 5 is a plan view of the work infeed stage.

In Fig. 4, reference numeral 74 designates a housing, reference numeral 75 designates a foot portion, reference numeral 76 designates a control board, reference numeral 77 designates a speed adjusting screw, reference numeral 78 designates an emergency stop button, and reference numeral 79 designates a direction of feeding a work to the work infeed stage.

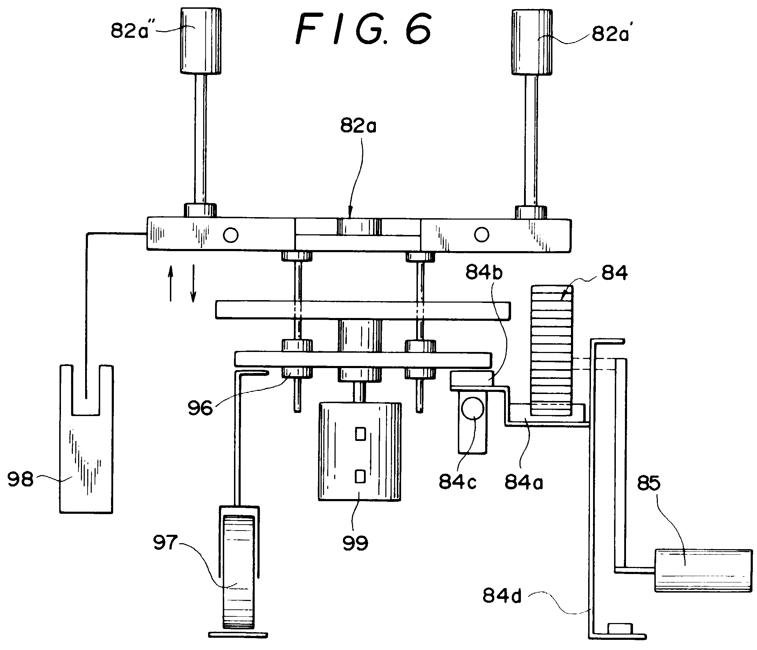

In Fig. 5, reference numeral 74 designates a housing of the prealignment stage, reference numeral 79 designates a direction of feeding each work 11 to the prealignment stage, reference numeral 80 designates a work infeed roller for conveying the work 11 toward a center 81 of the prealignment stage, and reference numerals 82a, 82b, 82c and 82d designate locators arranged forward, rearward, rightward and leftward of the work infeed rollers 80, respectively. When the foremost end of the work 11 conveyed by the work infeed rollers 80 reaches the position where a X-coordinate work sensor 83 is installed, locator pins 82a′, 82a˝, 82b′, 82b˝, 82c′, 82c˝, 82d′ and 82d˝ are supported by locators 82a, 82b, 82c and 82d, as typically illustrated in Fig. 6 only with respect to the locator pins 82a′ and 82a˝ for the purpose of simplification of illustration. As a cylinder 99 for displacing the locator pins 82a′, 82a˝, 82b′, 82b˝, 82c′, 82c˝, 82d′ and 82d˝ in the upward/downward direction is actuated and its piston is then raised up, each of the respective locator pins 82a′, 82a˝, 82b′, 82b˝, 82c′, 82c˝, 82d′ and 82d˝ is projected upward of the horizontal plane of the work infeed rollers 80.

For the purpose of simplification, description will be made below only with respect to the locator pins 82a′ and 82a˝, as shown in Fig. 6. As the locator 82 for supporting the locator pins 82a′ and 82a˝ is rotationally driven by a motor 85 (see Fig. 6), the lower surface side of an endless timing belt 84 extending around the locators 82a and 82b (see Fig. 6) is operatively engaged with an engagement member 84a via a guide rail 84c and a guide member 84b held on the guide rail 84c. In Fig. 6, reference numeral 96 designates an auxiliary cylinder, reference numeral 97 designates a caster for supporting the auxiliary cylinder 96, reference numeral 98 designates a sensor installed below the locator 82a to stop displacement of the locator 82a in cooperation with the X-coordinate work sensor 83, and reference numeral 84d designates a supporting member for rotationally supporting shafts of the endless timing belt 84. Although the locator 82b is not shown in Fig. 6, it is operatively engaged with the upper surface side of the endless timing belt 84. With such construction, when the endless belt 84 is recirculatively driven as the motor 85 is rotated, the locator 82a squeezes the work 11 from behind in the leftward direction as seen in Fig. 5 so as to displace the work 11 toward the center 81 in the X-coordinate direction of the prealignment stage. On the other hand, the locator 82b squeezes the work 11 in the rightward direction in Fig. 5 until the work 11 is properly located at the center 81 of the prealignment stage and displacement of the work 11 is stopped.

Similarly, the locator 82c is operatively engaged with the upper surface side of another endless timing belt (not shown) adapted to be recirculatively driven by a motor 87 (see Fig. 5), while the locator 82d is operatively engaged with the lower surface side of the foregoing endless timing belt (not shown). As the motor 87 is rotationally driven, the rearmost end of the work 11 is squeezed and displaced toward the center 81 of the prealignment stage in the Y- coordinate direction of the same by the locators 82c and 82d. When the work 11 is properly located at the center 81 of the prealignment stage, displacement of the work 11 is stopped.

In addition, in Fig. 5, reference numeral 89 designates a work receiving roller for receiving a work to be conveyed in the prealignment stage, reference numeral 90 designates a supporting plate for supporting the work infeed rollers 80, and reference numeral 91 designates a Y-coordinate work sensor.

In a case where the work 11 to be located at the center 81 of the prealignment stage has a thin thickness, when the locator 82a squeezes the rearmost end of the work 11 at an excessively high speed, there arises a malfunction that a shape of the work is distorted undesirably. To avoid this malfunction, the adjustment screw 77 is installed as illustrated in Fig. 4 so as to adjust a rotational speed of the motor 85 thereby to adjust a speed of recirculative displacement of the endless timing belt 84.

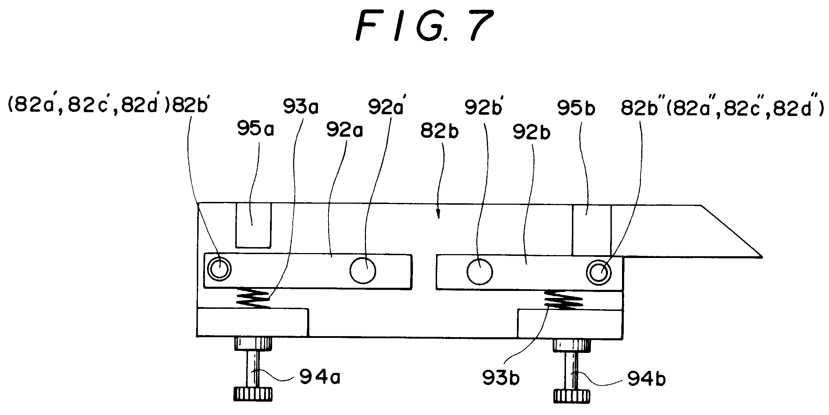

Fig. 7 is a plan view of a locator, particularly illustrating the position assumed by locator pins. As shown in the drawing, the central parts of locator pin mounting bases 92a and 92b are immovably held by locator shaft stoppers 92a′ and 92b′. For the purpose of simplification, description will be made below only with respect to the locator 82b. It is obvious that things are same with respect to each of the locators 82a, 82c and 82d.

The outer side of the locator 82b having locator pins 82b′ and 82b˝ mounted thereon is turnably mounted, and springs 93a and 93b are arranged outside of the locator pins 82b′ and 82b˝ so as to resiliently squeeze the locator shaft stoppers 92a and 92b against the locator 82b while properly adjusting a turning angle of each of the locator pins 82b′ and 82b˝ with the aid of adjustment screws 94a and 94b. In Fig. 7, reference numeral 95a and 95b designate locator pin stoppers, respectively. The adjustable resilient thrust force derived from the springs 93a and 93b makes it possible to properly locate the locator pins 82b′ and 82b˝ without an occurrence of undesirable inclination of the work 11 due to distortion of the work 11 at the center 81 of the prealignment stage, even though the opposite ends of the work 11 are not properly formed at a right angle relative to the X- coordinate.

When the prealignment stage as described above is mounted in operative association with the automatic optical exposing apparatus of the present invention shown in Fig. 1, it is recommendable that the direction of inserting a work into the prealignment stage through a work insert slit is determined in consideration of convenience of practical usage of the automatic optical exposing apparatus of the present invention.

According to the embodiment of the present invention, since the prealignment stage is constructed in the above-described manner, the work 11 which has been conveyed to the prealignment stage is properly located at the center 81 of the prealignment stage. After the position of the work 11 has been determined in that way, the work 11 is picked up by the infeed handler 5 and then conveyed to the alignment table 6 by the traverser 32. With the automatic optical exposing apparatus 1 of the present invention constructed in the above-described manner, a time required for positional alignment of the work 11 with the mask film 38 can be shortened. In addition, the foregoing positional alignment of the work 11 with the mask film 38 can be executed on the real time basis.

As is readily apparent from the above description, according to the present invention, since three work holding mechanisms are simultaneously driven within the operative range defined by a work infeed state, a position aligning stage, an optical exposing stage and a work outfeed stage by a single driving system, positional alignment of a work with the mask film can be executed on the real time basis in other location rather than the optical exposing stage.

In addition, since a reduced pressure chamber for firmly holding the work can be shifted into one of plural zones by an area shifter, the work can reliably be held with a few air leakage no matter how dimensions of respective works differ from work to work. Since the reduced pressure chamber is molded of a rubber, this makes it possible for the reduced pressure chamber to attractively hold the work of which substrate has a large number of apertures ranging from 8,000 to 15,000 formed thereon. Thus, in contrast with the conventional rubber pad, there do not arise malfunctions that the work falls down during its conveyance in a suspended state because of a shortage in suction force, and moreover, an image position given to the work is undesirably dislocated due to positional deviation of the work during an attractive holding operation. In addition, since a plurality of slits or holes are formed on the bottom surface of the reduced pressure housing, the work can be displaced in a suspended state in the horizontal direction without necessity for drawing a work substrate having a thin flexible intermediate layer. Additionally, since the reduced pressure chamber has an excellent property of light resistance, the reduced pressure chamber can practically be used for a long period of time without necessity for frequently replacing the reduced pressure chamber with another new one no matter how the work is exposed to bright light at the optical exposing stage.

While the present invention has been described above with respect to a single preferred embodiment thereof, it should of course be understood that the present invention should not be limited only to this embodiment but various changes or modifications may be made without departure from the scope of the invention as defined by the appended claims.

## Claims

1. An automatic optical exposing apparatus provided with a work infeed stage (3), a position aligning stage to receive an unexposed work (11) being conveyed from the work infeed stage through a traverser (32) to place said work (11) on an alignment table (6) in the position aligning stage, the alignment table (6) being automatically moved to adjust to place said work (11) to a predetermined exposing position when said work is conveyed to a next exposing stage (2), the exposing stage (2) serving to expose said unexposed work (11) which is conveyed from the position aligning stage through the traverser (32) by closely attaching said work (11) to a mask film (38) fixed on a lower printing frame in the exposing stage (2), and an outfeed stage to feed out said exposed work (11) conveyed from the exposing stage (2) through the traverser (32), characterized in that said work infeed stage is provided with a device to automatically place the central position of said unexposed work (11) at a predetermined position in said infeed stage, by a conveying system including three sets of work holding mechanism (5, 32, 37) and reciprocating between the two adjacent stages among said infeed stage, position aligning stage, exposing stage and outfeeding stage, and in that said work holding mechanism (5, 32, 37) of the conveying system reciprocating between said position aligning stage and said exposing stage (2) is formed as a reduced pressure housing provided with a plurality of air suction slits or holes (45a, 45b) and functions as an upper printing frame.

2. An automatic optical exposing apparatus according to claim 1, characterized in that the infeed stage is provided with a roller table, a plurality of work infeed rollers (80) horizontally, four sets of locators (82a, 82b, 82c, 82d) advancing to the center of the roller table when said work (11) is conveyed to a predetermined position, the four sets of the locators (82a, 82b, 82c, 82d) being situated near the edge portions in four directions, namely, forward and rearward, leftward and rightward, of said roller table when said roller table standing still, a pair of mounting bases of locator pins (82a', 82a'', 82b', 82b'', 82c', 82c'', 82d', 82d'') rotatably disposed on each of the locators and provided with said locator pins vertically at each opposite end of each locator, springs (93a, 93b) disposed to force the sideward of said mounting bases to the center of said roller table, and a device to lift up each of the locators to protrude said locator pins above said roller table when determining the position of said work (11).

## Patentansprüche

1. Automatisches optisches Belichtungsgerät, das mit einem Werkstück-Einführabschnitt (3), das mit einem Positionsausrichtungsabschnitt zum Empfangen eines unbelichteten Werkstücks (11), das von dem Werkstück-Einführabschnitt durch eine Schiebeeinrichtung (32) befördert wird, um das Werkstück (11) auf einem Ausrichtungstisch (6) in dem Positionsausrichtungsabschnitt zu plazieren, wobei der Ausrichtungstisch (6) automatisch zum Ausrichten bewegt wird, um das Werkstück (11) zu einer vorbestimmten Belichtungsstelle zu plazieren, wenn das Werkstück zu einem nächsten Belichtungsabschnitt (2) befördert wird, wobei der Belichtungsabschnitt (2) dazu dient, das unbelichtete Werkstück (11) zu belichten, das von dem Positionsausrichtungsabschnitt durch die Schiebeeinrichtung (32) dadurch befördert wird, daß das Werkstück (11) dicht an einem Maskenfilm (38) angebracht wird, der an einem unteren Druckrahmen in dem Belichtungsabschnitt (2) befestigt ist, und das mit einem Herausführabschnitt versehen ist, um das von dem Belichtungsabschnitt (2) durch die Schiebeeinrichtung (32) beförderte, belichtete Werkstück (11) herauszuführen, gekennzeichnet dadurch, daß der Werkstückeinführabschnitt mit einer Einrichtung zum automatischen Anordnen des mittigen Bereichs des unbelichteten Werkstücks (11) an einer vorbestimmten Stelle in dem Einführabschnitt versehen ist, durch ein Fördersystem, das drei Sätze von Werkstück-Haltemachanismen (5, 32, 37) aufweist und sich zwischen den beiden benachbarten Abschnitten unter dem Einführabschnitt, dem Positionsausrichtungsabschnitt, dem Belichtungsabschnitt und dem Herausführabschnitt hin- und herbewegt, und daß der Werkstück-Haltemechanismus (5, 32, 37) des Fördersystems, der sich zwischen dem Positionsausrichtungsabschnitt und dem Belichtungsabschnitt (2) hin- und herbewegt, als ein Gehäuse mit reduziertem Druck ausgebildet ist, das mit einer Vielzahl von Luftsaugschlitzen oder -löchern (45a, 45b) versehen ist und als oberer Druckrahmen wirkt.

2. Automatisches, optisches Belichtungsgerät nach Anspruch 1, gekennzeichnet dadurch, daß der Einführabschnitt mit einem Rollentisch, mit einer Vielzahl von Werkstückeinführrollen (80) in horizontaler Richtung, mit vier Sätzen von Lokalisierern (82a, 82b, 82c, 82d), die sich zur Mitte des Rollentisches bewegen, wenn das Werkstück (11) zu einer vorbestimmten Stelle befördert ist, wobei die vier Sätze von Lokalisierern (82a, 82b, 82c, 82d) nahe den Randbereichen in vier Richtungen, nämlich nach vorne und nach hinten, nach links und nach rechts, des Rollentisches angeordnet sind, wenn der Rollentisch stillsteht, wobei ein Paar von Montagerundteilen von Lokalisierstiften (82a', 82a'', 82b', 82b'', 82c', 82c'', 82d', 82d'') drehbar auf jeden der Lokalisierer angeordnet und mit den Lokalisierstiften in vertikaler Richtung an jeweils den gegenüberliegenden Enden jedes Lokalisierers versehen ist, mit Federn (93a, 93b) die vorgesehen sind, um die Seitliche der Montagegrundteile zur Mitte des Rollentisches zu treiben, und mit einer Einrichtung zum Anheben jeder der Lokalilsierer versehen ist, um die Lokalisierstifte über den Rollentisch nach oben herausragen zu lassen, wenn die Position des Werkstückes (11) festgelegt wird.

## Revendications

1. Appareil d'exposition optique automatique muni d'un étage d'alimentation en pièces (3), d'un étage d'alignement de position destiné à recevoir une pièce (11) non exposée en cours de transport depuis l'étage d'alimentation en pièces par l'intermédiaire d'un transbordeur (32) pour placer ladite pièce (11) sur une table d'alignement (6) dans l'étage d'alignement de position, la table d'alignement (6) étant automatiquement déplacée afin de placer ladite pièce (11) en une position d'exposition prédéterminée lorsque ladite pièce est transportée jusqu'à l'étage d'exposition (2) suivant, l'étage d'exposition (2) servant à exposer ladite pièce (11) non exposée qui est transportée depuis l'étage d'alignement de position par l'intermédiaire du transbordeur (32) en fixant étroitement ladite pièce (11) à un film de masquage (38) fixé sur un cadre d'impression inférieur dans l'étage d'exposition (2), et d'un étage de sortie destiné à évacuer ladite pièce (11) exposée transportée de l'étage d'exposition (2) par l'intermédiaire du transbordeur (32), caractérisé en ce que ledit étage d'alimentation en pièces est muni d'un dispositif destiné à placer automatiquement la position centrale de ladite pièce (11) non exposée en une position prédéterminée dans ledit étage d'alimentation, par un système de transport comprenant trois groupes de mécanismes de maintien de pièce (5, 32, 37) et se déplaçant en va-et-vient entre les deux étages adjacents parmi ledit étage d'alimentation, ledit étage d'alignement de position, ledit étage d'exposition et ledit étage de sortie, et en ce que ledit mécanisme de maintien de pièce (5, 32, 37) du système de transport allant en va-et-vient entre ledit étage d'alignement de position et ledit étage d'exposition (2) est formé en tant que compartiment à pression réduite muni d'une pluralité de fentes ou de trous d'aspiration d'air (45a, 45b) et fonctionne en tant que cadre d'impression supérieur.

2. Appareil d'exposition optique automatique selon la revendication 1, caractérisé en ce que l'étage d'alimentation est muni d'une table à rouleaux, d'une pluralité de rouleaux d'alimentation de pièces (80) horizontalement, quatre groupes de positionneurs (82a, 82b, 82c, 82d) avançant vers le centre de la table à rouleaux lorsque ladite pièce (11) est transportée jusqu'à une position prédéterminée, les quatre groupes de positionneurs (82a, 82b, 82c, 82d) étant situés près des parties de bord dans les quatre directions, à savoir vers l'avant, l'arrière, la droite et la gauche, de ladite table à rouleaux lorsque ladite table à rouleaux est immobile, une paire de bases de montage de broches de positionneur (82a', 82a", 82b', 82b", 82c', 82c", 82d', 82d") disposées rotatives sur chacun des positionneurs et munies desdites broches de positionneurs verticalement aux extrémités opposées de chaque positionneur, des ressorts (93a, 93b) destinés à pousser le côté de chaque base de montage vers le centre de ladite table à rouleaux, et un dispositif pour lever chacun des positionneurs pour faire sortir lesdites broches de positionneur au-dessus de ladite table à rouleaux lors de la détermination de la position de ladite pièce (11).
